# EUROPEAN PATENT SPECIFICATION

(11) **EP 0 253 892 B1**
(45) Date of publication and mention of the grant of the patent: **06.04.1994**
(21) Application number: 87900284.8
(22) Date of filing: 26.12.1986
(51) Int. Cl.: H05K 3/20, H05K 3/46, H05K 1/09

(54) **TRANSFER MATERIAL FOR PRINTED CIRCUIT BOARD AND PRINTED CIRCUIT BOARD PREPARED USING SAID TRANSFER MATERIAL AND PROCESS FOR PREPARATION THEREOF**
ÜBERTRAGUNGSMATERIAL FÜR GEDRUCKTE LEITERPLATTE, SOWIE VORBEREITETE GEDRUCKTE LEITERPLATTE ZUR VERWENDUNG DIESES ÜBERTRAGUNGSMATERIALS UND VERFAHREN ZUR HERSTELLUNG
MATERIAU DE TRANSFERT POUR CARTE DE CIRCUIT IMPRIME, CARTE DE CIRCUIT IMPRIME PREPAREE EN UTILISANT LEDIT MATERIAU DE TRANSFERT ET PROCEDE DE PREPARATION

(30) Priority: 28.12.1985 JP 299179/85; 30.05.1986 JP 126662/86; 11.08.1986 JP 188826/86; 17.11.1986 JP 273121/86
(43) Date of publication of application: 27.01.1988
(73) Proprietor: Nissha Printing Co., Ltd., Nakakyo-ku Kyoto-shi Kyoto-fu 604 (JP)
(72) Inventor: TAKAOCHI, Minoru, Osaka 590-02 (JP); YAMANAKA, Tsuneyuki, Otsu-shi Shiga 520-21 (JP); FUJIMURA, Toshitsugu, Nakagyo-ku, Kyoto-shi Kyoto 604 (JP); MORI, Fujio, Kyoto-shi Kyoto 616 (JP)
(74) Representative: Glawe, Delfs, Moll & Partner
(86) International application number: JP8600654
(87) International publication number: WO8704315

(56) References cited:
- EP-A- 0 091 075
- EP-A- 0 177 829
- JP-A-49 105 856
- JP-A-54 142 575
- JP-A-60 121 791
- JP-B- 562 435
- US-A- 3 085 295
- WESCON PROCEEDINGS, 19th-22nd November 1985, San Francisco, CA, vol. 29, pages 1-5, New York, US; S.B. RIMSA: "New transfer method for the manufacture of molded 3-dimensional printed circuit boards and chip carriers"

## Description

### FIELD OF THE INVENTION

The present invention relates to techniques applicable to the production of printed circuits wherein a circuit pattern is printed in the manner of transfer printing onto the surface of a circuit substrate simultaneously with the molding of the substrate. More particularly, this invention relates to a method of producing the printed circuit with application of the technique of forming a circuit pattern on the surface of a substrate simultaneously with the molding of said substrate in a mold in the manner of injection molding.

### BACKGROUND OF THE INVENTION

As regards the production of printed circuits, various methods have been proposed in the past. The present applicant proposed a manufacturing method wherein, by using a transfer material which had a layer of circuit pattern therein as a constituent layer, a sheet with an electrical circuit pattern thereon, which consisted of a circuit pattern formed on a sheet substrate which was removable, was placed in position in a mold for injection molding and then a heat-resistant molten thermoplastic resin was injected into said mold in such a manner as to place said electrical circuit pattern on the substrate which was formed, and the sheet substrate thereafter was removed (ref. Japanese first Patent Publication No. 121791/1985). This method had the following advantages compared with the methods which had been in general practice: (a) circuit pattern could be formed on three-dimensional substrate; (b) the manufacturing process could be rationalized into a shorter procedure; and (c) the method dispensed with after-procedure, such as boring fastening holes, ribbing and blanking the periphery.

Ordinarily, however, substrates for printed circuits are required to have good mechanical strength, electrical properties, heat resistance, etc. and therefore, the resin from which the substrate is made was restricted to a thermoplastic resin having a high melting point. Therefore, the injection molding of printed circuits has required the mold temperature and the resin temperature to be higher than the injection molding of ordinary resins.

As a result, an attempt to form a circuit pattern on the surface of a substrate by the use of a conventional transfer material for the general application, simultaneously with the molding of the substrate by a technique of injection molding, has involved the following problems: (1) If an ordinary thermoplastic resin is used as a binder in the conductive ink or in the insulating ink that forms a layer of circuit pattern in the transfer material for a printed circuit, the layer of circuit pattern melts away in a molten resin injected when the molding resin is injected, whereas, (2) if a thermosetting resin is used as a binder in the conductive ink or the insulating ink and is sufficiently hardened when used in a transfer material so as for the layer of circuit pattern in the transfer material not to melt away, the layer of circuit pattern fails to soften when the molding resin is injected and a poor adhesion results between the layer of circuit pattern and the molding resin.

A method of the kind defined in the preamble of claim 1 has been known from the document Wescon Proceedings, 19th to 22nd November 1985, San Francisco, Vol. 29, p. 1-5. According to this document, the circuit pattern layer is transferred to pre-molded substrate in a separate transfer step applying heat and pressure. EP-A-0177829 which is prior art under article 54 (3) EPC describes a method for transferring a printed pattern (not a printed circuit pattern) onto a three-dimensional article by placing a base film carrying the printed pattern in an injection mold and injection molding the article.

An object of the present invention is, as a solution to the above-mentioned problems, to provide a method of manufacturing printed circuits according to which a printed circuit wherein an accurate circuit pattern having a good adhesion to the substrate is formed can be obtained in a simple process, without involving the trouble of the layer of circuit pattern melting when the molding resin is injected or the trouble of it melting away in the molten resin injected, by the use of a transfer material for printed circuits.

### SUMMARY OF THE INVENTION

For solving this object the invention provides the method as defined in claim 1. Claims 2 to 5 define preferred further embodiments of the method according to the invention.

### BRIEF DESCRIPTION OF THE DRAWINGS

Fig. 1 illustrates a cross section of a transfer material for a printed circuit for use in the method of the present invention;
Figs. 2 through 4 illustrate each a cross section of other transfer materials for a printed circuit for use in the method of the present invention;
Fig. 5 illustrates a cross section of a printed circuit made according to the present invention;
Fig. 6 illustrates the same printed circuit as in Fig. 5, except that the lands are each provided with a metal cover in Fig. 6;
Fig. 7 illustrates a mold in a clamped position in the manufacture of a printed circuit according to the present invention; and
Fig. 8 illustrates in cross-section representation a mold in a "mold touch" position in the manufacture of a printed circuit according to the present invention.

The above drawings are given without regard to dimensions of the constituent elements relative to each other but with magnification or diminution where necessary in order to make the illustrations clear.

### PREFERRED EMBODIMENTS OF THE INVENTION

There are now provided detailed explanations of transfer materials for printed circuits for use in the present invention with reference to the drawings.

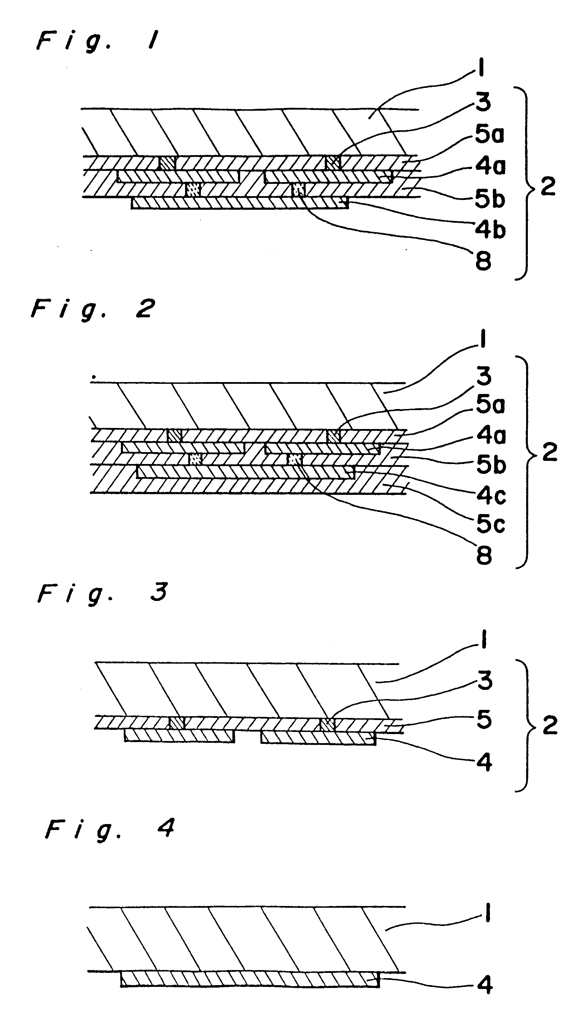

Fig. 1 shows a transfer material T for a printed circuit. The transfer material T consists of a sheet substrate 1 and a layer of circuit pattern 2, and the layer of circuit pattern 2 comprises lands 3, layers of conductive pattern 4 (4a, 4b), insulative layers 5 (5a, 5b), and through holes 8.

A transfer material T for a printed circuit provided according to the present invention uses a resin as mentioned below for the outermost surface layer of the layer of circuit pattern 2, i.e., the layer placed in contact with the substrate of a printed circuit. To be strict, the outermost surface layer of a layer of circuit pattern 2 does not consist of a resin alone but contains an electroconductive powder etc. if it constitutes a layer of conductive pattern 4 or an insulative powder etc. if it constitutes an insulative layer 5. For conveniences' sake in the present explanations, the portion of a substance which fills the spaces between the particles of a powder etc. in the outermost surface layer is referred to as the outermost surface layer.

Said resin is a thermoplastic resin which starts to be thermally deformed at a temperature in the range 120°C - 300°C, and preferably in the range 150°C - 250°C.

The reason for the use of such a resin is to carry out the transfer printing without causing the outermost surface layer of a layer of circuit pattern 2 to be molten, except for slight softening, when is comes in contact with a molten molding resin. In transfer printing, a molding resin in the molten state functions as an adhesive and accomplishes a tight adhesion between a layer of circuit pattern and the surface of a substrate molded from said molding resin. The resins useful for this purpose include: polyether sulfone, polysulfone, polyether imide, polyamide imide, polyaryl sulfone, polyarylate, polyphenylene oxide, polyphenylene sulfone, polycarbonate, and polyamide.

In Fig. 1 the outermost surface layer consists of a layer of conductive pattern 4b and an insulative layer 5b.

Fig. 2 illustrates a transfer material T for a printed circuit as another embodiment of the present invention. The outermost surface layer of this transfer material T consists entirely of an insulative layer 5c. This insulative layer 5c corresponds to what is called "adhesive layer" in the transfer materials in conventional use. It is preferred to select and use as its constituent material a resin which will have a good adhesion to the molding resin which will be specified later in this specification.

Figs. 3 and 4 illustrate each a transfer material T for a printed circuit as a different embodiment of the present invention. In Fig. 3 the outermost surface layer of the transfer material T consists of a layer of conductive pattern 4 and an insulative layer 5. In Fig. 4 the transfer material T has a layer of conductive pattern 4 for its outermost surface layer.

There are now provided detailed explanations of the constituents other than the outermost surface layer relating to the transfer materials T used for manufacturing printed circuits in the method embodying the present invention.

The materials suitable for use for the sheet substrate 1 in a transfer material T embodying the present invention include films of polyester, polyimide, polyether sulfone, polyether ethyl ketone, polyphenylene sulfide, polymethyl pentene, polyethylene, and polypropylene, each used either as a simple substance or a composite. Release treatment, such a silicone treatment, may be applied to the films where preferable.

Lands 3 are provided to a transfer material as a means for mounting IC parts etc. by soldering and may be formed of polymer type inks containing silver, copper, nickel, etc. The content of the silver, copper, nickel, etc. in a polymer type ink is preferred to be somewhere in the range 50% through 90% by weight, especially in the range 60% through 85% by weight. Demerits also accompany the use of such polymer type inks, however. For example, when the polymer type ink contains silver, soldering causes the silver to migrate into the solder and the soldering to end in an unsatisfactory result. When a polymer type ink does not contain silver but does contain copper, nickel, etc., the above-mentioned problem does not occur but a problem relating to heat resistance may arise from the heat of soldering.

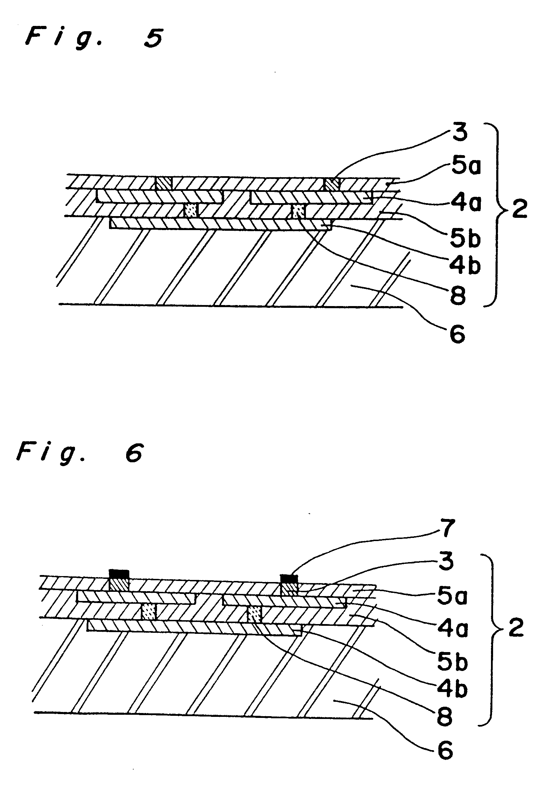

It is, therefore, preferable to form the lands 3 from a catalytic ink for chemical plating having good heat resistance, and furthermore, to provide each of the lands 3, after the transfer printing, with a metal covering 7 by a technique of chemical plating (see Fig. 6). By so doing a highly reliable printed circuit having a good stability relating to soldering can be obtained.

The catalyzers suitable for use in said catalytic inks include palladium, tin, indium, titanium, silver, copper, nickel, and aluminum, each used either independently or in combination with others. The content of such a catalyzer or catalyzers in a catalytic ink is preferred to be somewhere in the range 90% through 98% by weight, especially in the range 95% through 98% by weight. The advantage of the use of such a metal as the catalytic component in a catalytic ink is that the chemical plating using a metal, such as copper, nickel, silver, tin, cobalt, gold, and a nickel alloy, can be carried out by autocatalytic-reduction of the metal powder used in a catalytic ink. The materials suitable as a binder in such catalytic inks include: epoxies, phenolics, polyesters, and acrylics, each being a thermosetting resin; or polyether sulfone, polysulfone, polyether imide, polyamide imide, polyaryl sulfone, polyarylate, polyphenylene oxide, polyphenylene sulfone, polycarbonate, and polyamide, each being a thermoplastic resin. It is practical to use a surface-active agent, thixotropic auxiliary, etc. as an additional component of a catalytic ink to improve the printing ink properties. Also a resin which can be cured by heat as well as by UV light can be used as a binder in a catalytic ink.

Said layer of conductive pattern 4 is formed from a conductive ink prepared from an even mixture of a conductive powder, binder, solvent, etc. and by a suitable printing means. Suitable for the conductive powder in a conductive ink are silver, aluminum, copper, nickel, gold, carbon, graphite, glass beads coated with a metal, inorganic conductive powder, etc. When a layer of conductive pattern 4 forms an outermost surface layer, one of the three resins (1) through (3) in the foregoing explanation is used for the binder in the conductive ink. When a layer of conductive pattern 4 does not form an outermost surface layer, any resin suitable with regard to conductivity, heat resistance, adhesion to the adjoining layers, etc. can be used, including any resin for the conductive inks in conventional use. Said conductive ink may contain a surface-active agent, an agent for imparting thixotropy, etc. as a means to improve the printing ink properties.

Said insulative layer 5 is formed from an insulative ink prepared by evenly mixing an insulative powder, binder, solvent, etc. and by a suitable printing means as in forming a layer of conductive pattern 4. The insulative powder suitable for an insulative ink is an inorganic powder such as a chromic oxide, alumina, silicon dioxide, zirconium oxide, magnesium oxide, beryllium oxide, boron nitride, mica, magnesium silicate or steatite. Such an insulative powder, however, is not essential in the composition of an insulative ink. For the binder for an insulative ink, when the insulative layer 5 forms an outermost surface layer, one of the three resins (1) - (3) in the foregoing explanation is used, as is so with the binder for a conductive ink. When the insulative layer 5 does not form an outermost surface layer, any resin suitable with respect to insulation, heat resistance, adhesion to the adjoining layers, etc. can be used, including any resin for insulative inks in conventional use. Said insulative ink may contain a surface-active agent, an agent for imparting thixotropy, etc. as a means to improve the printing ink properties.

Through holes 8 may be formed through the insulative layer 5b for the connection between layers of conductive pattern 4a, 4b, as occasion demands (see Figs. 1 and 2).

Through holes 8 can be formed with a conductive ink and by a suitable printing method. An insulative layer 5a may function as a solder resist as well when it forms a surface layer after the transfer printing.

Referring now to Figs. 5 through 8, there are provided detailed explanations with respect to a printed circuit P embodying the present invention and the method of its manufacture.

Said transfer material T for a printed circuit is set in position for the transferring in a mold 9 for injection molding where a substrate 6 is molded. The setting is to cause the outermost surface layer of the transfer material T to come in contact with a molten resin 10 which will be specified later in this specification.

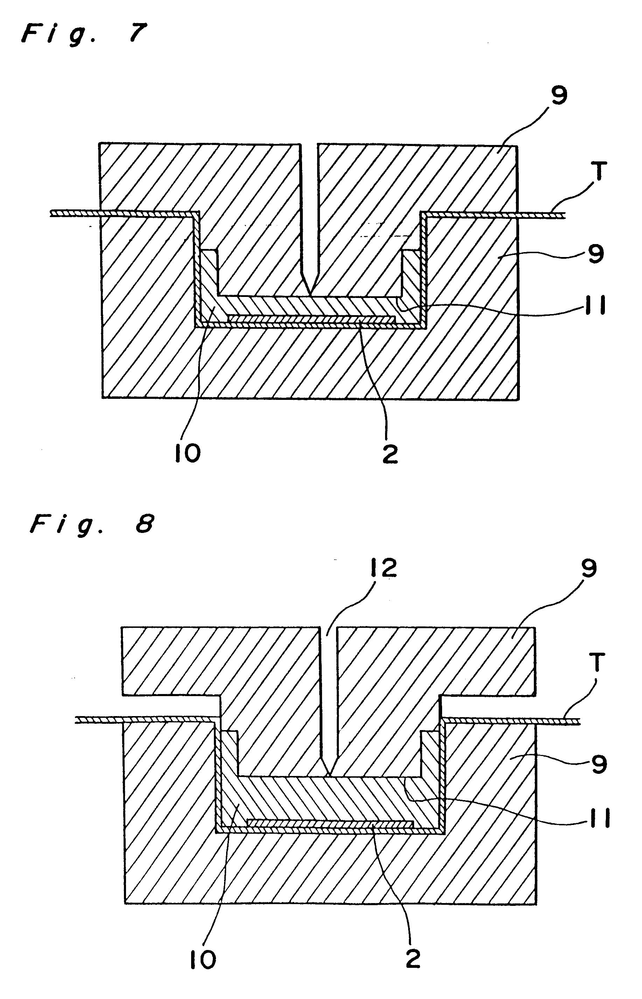

The mold 9 is clamped, an a molten resin 10 is injected into the cavity 11 defined internally by the mold 9 (see Fig. 7). The mold is used approximately in the temperature range 80°C - 180°C and the resin likewise in the range 250°C - 400°C, such conditions varying according to the kinds of the molding resin and the shape of the mold.

The resin to form a substrate 6 in an embodiment of the method of the present invention is required to be good in both mechanical and electrical properties and in heat resistance. Applicable to this purpose are, for example, thermoplastic resins such as polyether sulfone, polyether imide, polyether ethyl ketone, polysulfone, polyarylate, polybutylene terephthalate, and polyethylene terephthalate. Glass fibre, mica, talc, titanium oxide, etc. can be used as additives to the resins, as the occasion may demand, for the purpose of adjusting the properties of the substrate 6 to be formed.

The molten resin 10 injected is cooled and solidified, and then the mold 9 is opened and the molding is taken out. The sheet substrate 1 thereon is taken off.

A printed circuit P embodying the present invention is obtained through the above-mentioned procedure. Since simultaneously with the molding formation of a substrate a layer of circuit pattern is printed onto it in the manner of transfer printing, the outermost surface layer of the layer of circuit pattern, that is, the surface opposite to the substrate, assumes an even plane. Furthermore, since pressure is applied to a layer of circuit pattern in the transfer printing, an improvement in conductivity is possible depending on the kind of the conductive ink. The transfer material T for a printed circuit shown by Fig. 1 produces a printed circuit shown by Fig. 5.

A land 3, as occasion demands, is provided with chemical plating to form a metal cover 7 thereon, the plating material being one from among copper, nickel, silver, tin, cobalt, and gold, or a nickel alloy such as nickel-cobalt, nickel-tungsten-phosphorus, or nickel-iron-boron. By forming such a metal cover 7 a highly reliable printed circuit having a good soldering stability as in the foregoing explanation can be obtained (see Fig. 6).

A circuit pattern can also be heat-treated, if necessary, to improve the adhesion property between the substrate 6 and the layer of circuit pattern 2. Where a UV light-curable resin is used, a circuit pattern can be subjected to curing by UV light irradiation.

Another method applicable to the production of a printed circuit P is as follows. As a step for the injection of a molten resin 10 the mold 9 is put in position for "mold touch" before clamping (see Fig. 8). While the mold 9 is held in this position, a molten resin 10 is injected into its cavity 11, and the mold 9 is clamped (see Fig. 7). In this way, by clamping immediately following the injection of a molten resin 10 into the cavity 11 of the mold 9 the resin 10 is compressed and given expansive pressure at all points in the cavity 11 of the mold 9 while being shaped into a substrate 6. Needless to say, at this moment, the tip of the injection nozzle 12 of the molten resin 10 is closed. The clamping force applied varies depending on the kind of the molding resin and the shape of the substrate 6. It is practical to apply the clamping force in two or more grades, stepwise for example, a weak force at the first step and a strong force next. The "mold touch" refers to the condition where the mold 9 has been so adjusted as to form a cavity 11 therein which permits itself to be filled with a molten resin 10 under clamping force of 0 kg/cm².

This second-mentioned method has, besides the advantages of the first-mentioned method, i.e., formation of an even plane on the outermost surface side of the layer of circuit pattern, and so on, the following advantages. Since the molten resin is injected while the mold is in "mold touch" and pressurized by clamping, the method makes good the poor fluidity of the molding resin. Because a larger cavity is provided when the resin is injected than when it is cooled and solidified, the molten resin proportionately has an ease in fluidity. The injection of molten resin into a cavity can be carried out under low pressure and the molding adaptability is widened, for example, this molding method being suitable for cases where the complexity of the molding cavity in contour impairs the fluidity of the molten resin therein, where the cavity is for thin substrates or substrates having an irregular surface instead of a plane, or where the melt viscosity of the molten resin is very high, or where the molding resin contains a filler, or the like. Since the molten resin is pressurized evenly at all points, the surface of the substrate and the layer of circuit pattern adhere firmly to each other and a printed circuit accurate in dimensions, free from warping and distortion, is obtainable according to this method. Even if, furthermore, the molding is heat-treated for an improvement in adhesion between the layer of circuit pattern and the substrate after the molding, no warping or distortion attributable to residual strain occurs.

In the practice of the first-mentioned or the second-mentioned method of molding printed circuits above, it is practical to use two transfer materials T for a printed circuit so as to form a layer of circuit pattern 2 on each surface of a substrate 6. It is also practical to use an insert material for a printed circuit as well as a transfer material for a printed circuit so as to form a layer of circuit pattern on the front surface of a substrate from the transfer material and another layer of circuit pattern on the back surface of the substrate from the insert. The insert for a printed circuit consists of a layer of circuit pattern formed on a sheet substrate directly without applying a release agent.

There are now provided examples of embodiments of the present invention (the word "parts" in the descriptions of the examples below refers in each case to parts in terms of "by weight").

### EXAMPLE 1

A transfer material T-1 for a printed circuit was made, wherein a layer of conductive pattern was formed by the screen printing of a required circuit pattern on a substrate of polyimide film 25 microns thick and by the use of a conductive ink shown as Composition 1.

A transfer material T-2 for a printed circuit was made, wherefor a required pattern was printed on a substrate of the same film as in T-1 above by screen printing and by the use of an insulative ink shown as Composition 2 and, after its complete drying, a layer of conductive pattern was formed on the substrate by the screen printing of a required circuit pattern and by the use of the conductive ink shown as Composition 1.

A transfer material T-3 for a printed circuit was made, wherein a required circuit pattern was formed on a substrate of the same film as in T-1 and T-2 above by screen printing and by the use of the conductive ink of Composition 1, the insulative ink of Composition 2, and the conductive ink of Composition 1 in this order. Through holes were put through the insulative layers so as to electrically connect the two layers of conductive pattern.

A transfer material T-4 for a printed circuit was made, wherein a required circuit pattern was printed on a substrate of the same film as in T-1 through T-3 by the use of the conductive ink of Composition 1, the insulative ink of Composition 3, and the conductive ink of Composition 1 in this order and by screen printing.

A transfer material T-5 for a printed circuit was made, wherein a polyethylene terephthalate film with a thickness of 50 microns and treated with a silicone release agent was printed, by screen printing, with a silver paste having an epoxy resin as a binder only at the positions (lands) where soldering is required, and with the insulative ink of Composition 2 at all other positions, and then a required pattern (including lands) was screen-printed thereon with a conductive ink of Composition 1.

Transfer materials T-1 through T-5 for printed circuits thus formed were set in position in molds and clamped and tested by injecting polyether sulfone resin as follows.

After the molten resin had cooled and solidified, the molds were opened and the moldings taken out were separated from the polyimide film and polyethylene terephthalate film.

The layer of circuit pattern in each printed circuit obtained showed a good adhesivion to the substrate and that there occurred no melting of the layer of circuit pattern.

The insulation between layers of conductive patterns in a printed circuit obtained by using the transfer materials T-3 and T-4 registered a value exceeding 1 x 10¹⁰Ω, whereas the electrical connection of the through holes proved satisfactory. The soldering properties of the printed circuit obtained by using the transfer material T-5, tested by dip soldering under conditions 260°C x 3 sec., were such that solder showed even overlay at positions printed with a silver paste while there were no blisters caused by heat nor degrading in the adhesion.

| COMPOSITION 1 (Conductive Ink) | |
|---|---|
| polysulfone | 10 parts |
| silver (in flakes) | 67 parts |
| solvent (cyclohexanone; butyl Cellosolve acetate) | 23 parts |

| COMPOSITION 2 (Insulative Ink) | |
|---|---|
| polysulfone | 19.7 parts |
| alumina powder | 29.5 parts |
| solvent (cyclohexanone: butyl Cellosolve acetate) | 50.8 parts |

| COMPOSITION 3 (Insulative Ink) | |
|---|---|
| polyethersulfone | 20 parts |
| alumina powder | 30 parts |
| solvent (N-methyl-2-pyrrolidone: toluene) | 50 parts |

| MOLDING (Injection) CONDITIONS | |
|---|---|
| molding machine JC150SA | made by Nippon Seikohsho Co. Ltd. |
| mold temperature | 130 - 150°C |
| cylinder temperature | 350 - 380°C |
| injection pressure | 1700 kg/cm² |
| dwelling pressure | 1190 - 1241 kg/cm² |
| revolution | 50 rpm |
| The injection speed was the maximum speed of this molding machine | |

### EXAMPLE 2

A polyethylene terephthalate film release-treated by coating of an epoxy resin thereon and having a thickness of 38 microns was screen-printed to form a required circuit pattern thereon with a silver paste having a thermosetting phenolic resin as a binder, and then screen-printed to form another required pattern thereon with an insulative paste having a thermosetting epoxy resin as a binder, and screen-printed to form another required circuit pattern thereon with the above-mentioned silver paste. The printed substrate was furthermore screen-printed all over with on insulative ink of Composition 4 and heat-treated eventually to form a transfer material T-6 for a printed circuit.

A polyethylene terephthalate film silicone-treated for release and having a thickness of 38 microns was screen-printed to form a required circuit pattern with a silver paste having an epoxy resin as a binder. Subsequently, the printed substrate was screen-printed all over with an insulative ink of Composition 5 and heat-treated eventually to form a transfer material T-7 for a printed circuit.

A polyimide film with a thickness of 25 microns was screen-printed to form a required circuit pattern by the use of a conductive ink of Composition 1 and an insulative ink of Composition 4 in this order, and provided with a heat drying treatment to form a transfer material T-8 for a printed circuit.

Each of the transfer materials T-6 through T-8 thus obtained was set in position in a mold, clamped, and tested by injecting polyether sulfone resin as follows.

After the molten resin had cooled and solidified, the mold was opened, and the molding taken out was separated from the polyethylene terephthalate film or polyimide film.

Each of the printed circuits obtained, having two layers of conductive patterns, showed a good adhesion between the layer of circuit pattern and the substrate and that there occurred no melting of the layer of circuit pattern. The insulation between the layers of conductive pattern in the printed circuit obtained by using the transfer material T-6 registered a value exceeding 1 x 10¹¹Ω, whereas the electrical connection of the through holes proved satisfactory. The soldering properties of the printed circuit obtained by using the transfer material T-7, tested by dip soldering under conditions 260°C x 3 sec., were such that solder showed even overlay at positions printed with a silver paste while there were no blisters caused by heat nor degrading in the adhesion. With respect to electrical resistance of a printed circuit a pattern measuring 1 mm in width and 100 mm in length, produced by the transfer material T-8, registered a value of less than 10Ω.

| COMPOSITION 4 (Insulative Ink) | |
|---|---|
| polysulfone | 30 parts |
| silica powder | 5 parts |
| solvent (cyclohexanone; butyl Cellosolve acetate) | 65 parts |

| COMPOSITION 5 (Insulative Ink) | |
|---|---|
| polyether sulfone | 30 parts |
| alumina powder | 10 parts |
| solvent (N-methyl-2-pyrrolidone; toluene) | 60 parts |

| MOLDING (Injection) CONDITIONS | |
|---|---|
| molding machine JC150SA | made by Nippon Seikohsho Co. Ltd. |
| mold temperature | 100 - 120°C |
| cylinder temperature | 350 - 380°C |
| injection pressure | 1700 kg/cm² |
| dwelling pressure | 1190 - 1241 kg/cm² |
| screw revolution | 50 rpm |
| The injection speed was the maximum speed of this molding machine. | |

### EXAMPLE 3

A polyimide film with a thickness of 25 microns was screen-printed to form a required circuit pattern thereon with a conductive ink of Composition 6 and then heat-treated to produce a transfer material T-9 having the layer of conductive pattern in the half cured state.

The same film as for the transfer material T-9 was screen-printed to form a required circuit pattern thereon by the use of an insulative ink of Composition 7 and a conductive ink of Composition 6 in this order and then heat-treated to produce a transfer material T-10 having the layer of circuit pattern in the half cured state.

The same film as for the transfer material T-9 was screen-printed to form a required circuit pattern thereon by the use of a conductive ink of Composition 6, an insulative ink of Composition 7 and the conductive ink of Composition 6 in this order and then heat-treated to produce a transfer material T-11 having the layer of circuit pattern in the half cured state.

A polyethylene terephthalate film silicone-treated for release and having a thickness of 50 microns was screen-printed only at the soldering positions (lands) with a silver paste having an epoxy resin as a binder and the remaining surface was screen-printed with an insulative ink of Composition 7. This film was screen-printed to form a required pattern (including the lands) thereon with a conductive ink of Composition 6 and subsequently heat-treated eventually to form a transfer material T-12 having the layer-of circuit pattern in the half cured state.

Each of the transfer materials T-9 through T-12 thus obtained was set in position in a mold, clamped, and tested by injecting polyether sulfone resin and under the same conditions as in Example 1.

After the molten resin had cooled and solidified, the mold was opened and the molding taken out was separated from the polyimide film or polyethylene terephthalate film and subjected to heat treatment at 150°C for 30 minutes.

The layer of circuit pattern in each of the printed circuit thus obtained showed no melting but a good adhesion to the substrate. A printed circuit obtained by using the transfer material T-11 showed an insulative resistance value exceeding 1 x 10¹⁰Ω between the layers of conductive pattern and the electrical connection of the through holes proved satisfactory. The soldering properties of a printed circuit obtained by using the transfer material T-12, tested by dip soldering under conditions 260°C x 3 sec., were such that solder showed even overlay at the positions printed with a silver paste and there were no blisters at any other points of the surface nor degrading in the adhesion.

| COMPOSITION 6 (Conductive Ink) | |
|---|---|
| epoxy | 33 parts |
| silver (in flakes) | 61 parts |
| solvent (methyl ethyl ketone) | 5 parts |
| additive | 1 part |

| COMPOSITION 7 (Insulative Ink) | |
|---|---|
| epoxy | 33 parts |
| alumina powder | 65 parts |
| solvent (methyl ethyl ketone) and additive | 2 parts |

### EXAMPLE 4

A polyethylene terephthalate film release-treated by coating of an epoxy resin and having a thickness of 38 microns was screen-printed to form a required circuit pattern thereon with a silver paste having a thermosetting phenolic resin as a binder. This printed film was screen-printed to form a required pattern with an insulative paste having a thermosetting epoxy resin as a binder, then to form a required circuit pattern with the above-mentioned silver paste, and subsequently, screen-printed all over with an adhesive ink of Composition 8, and heat-treated eventually to obtain a transfer material T-13.

A polyethylene terephthalate film silicone-treated for release and having a thickness of 38 microns was screen-printed with a silver paste having an epoxy resin as a binder, and then screen-printed all over in the manner of overlaying with an insulative ink of Composition 9, and by subjecting it to heat treatment a transfer material T-14 was consequently obtained.

A polyimide film with a thickness of 25 microns was screen-printed to form a required circuit pattern by the use of a conductive ink of Composition 1 and an insulative ink of Composition 8 in this order, and by subjecting it to heat-drying a transfer material T-15 was obtained.

Each of the transfer materials T-13, T-14 and T-15 was set in position in a mold, clamped, and tested by injecting polyether sulfone resin under the same conditions as in Example 2.

After the molten resin had cooled and solidified, the mold was opened and the molding taken out was separated from the polyethylene terephthalate film or polyimide film, and subsequently subjected to heat treatment at 150°C for 30 minutes.

The printed circuits obtained as a result, having conductive patterns in a monolayer or in two layers, showed a good adhesion between the circuit pattern and the substrate and that there was no melting of the layer of circuit pattern. The printed circuit produced by the transfer material T-13 had an electrical insulative resistance of a value exceeding 1 x 10¹¹Ω between the layers of conductive pattern and the electrical connection of the through holes proved satisfactory. The soldering properties of the printed circuit produced by the transfer material T-14, tested by dip soldering under conditions 260°C x 3 sec., were such that solder showed even overlay at the positions printed with a silver paste and there was no blister caused by heat at any other point of the surface nor degrading in the adhesion. With respect to electrical resistance of a printed circuit a pattern measuring 1 mm in width and 100 mm in length, produced by the transfer material T-15, registered a value of less than 10Ω.

| COMPOSITION 8 (Insulative Ink) | |
|---|---|
| phenol | 60.5 parts |
| silica powder | 36.0 parts |
| solvent and surface-active agent | 3.5 parts |

| COMPOSITION 9 (Insulative Ink) | |
|---|---|
| epoxy | 85 parts |
| alumina powder | 10 parts |
| solvent and surface-active agent | 5 parts |

### EXAMPLE 5

A polyimide film with a thickness of 25 microns was treated for mold release, and screen-printed in the manner of overlaying to form a required circuit pattern with a conductive ink of the thermosetting as well as UV light curing type. Subsequently, by UV light irradiation a transfer material T-16 having a half cured layer of conductive pattern was obtained.

The transfer material T-16 was set in position in a mold and, following the clamping, tested by injecting polyether sulfone resin and under the same condition as in Example 1.

After the molten resin had cooled and solidified, the mold was opened and the molding taken out was separated from the polyimide film and then subjected to heat treatment at 150 C for 30 minutes.

A printed circuit obtained as a result, having a single layer of conductive pattern, showed a good adhesion between the layer of circuit pattern and the substrate and that there was no melting in the layer of circuit pattern.

### EXAMPLE 6

A polyethylene terephthalate film silicone-treated for mold release and having a thickness of 38 microns was screen-printed to form a required pattern thereon with a thermosetting silver paste having an epoxy resin as a binder and, after subjecting it to heat-curing treatment, screen-printed all over in the manner of overlaying with an insulative ink of the thermosetting as well as UV light curing type. Subsequently, by UV light irradiation a transfer material T-17 having the outermost surface layer in a half cured state was obtained.

The transfer material T-17 was set in position in a mold, and, after the clamping, tested by injecting polyether sulfone resin under the same conditions as in Example 2.

After the molten resin had cooled and solidified, the metal was opened, and the molding taken out was separated from polyimide film and then subjected to heat treatment at 150°C for 30 minutes. The soldering properties of the printed circuit thus obtained, tested by dip soldering under conditions 260°C x 3 sec., were such that solder showed even overlay at the positions printed with a silver paste and there was no blister caused by heat at any other point of the surface nor degrading in the adhesion.

### EXAMPLE 7

A polyethylene terephthalate film treated for mold release with an epoxy coating and having a thickness of 38 microns was screen-printed to form a required circuit pattern thereon with a silver paste having a thermosetting phenolic resin as a binder, and then to from a required pattern with an insulative paste having a thermosetting epoxy resin as a binder, and to form a required circuit pattern with the above-mentioned silver paste. Finally, this screen-printed film was screen-printed all over with an adhesive insulative paste having a thermosetting epoxy resin as a binder, and by subjecting it to heat treatment a transfer material T-18 was eventually obtained.

The transfer material T-18 thus obtained was set in a mold and tested by injecting polyether sulfone resin under the same condition as in Example 2.

After the resin had solidified, the mold was opened and the transfer material T-18 was set in position in a mold, and the mold was clamped again.

The transfer material T-18 was put in adhesion to the molding, and, after a dwelling time of 10 seconds, the mold was opened and the molding taken out was separated from the polyethylene terephthalate film, and by subjecting it to heating at 150°C for 30 minutes the resin was cured.

A printed circuit obtained as a result, having a conductive pattern in two layers, showed a good adhesion between the layer of circuit pattern and the substrate.

Tests proved the electrical connection between the layers of conductive pattern to be satisfactory and the insulation where needed to be perfect with the resistance exceeding 1 x 10¹¹Ω.

### EXAMPLE 8

A polyethylene terephthalate film silicone-treated for mold release and having a thickness of 38 microns was screen-printed to form the pattern of lands thereon with a thermosetting palladium ink having an epoxy resin as a binder, and furthermore screen-printed in a manner of overlaying by the use of an insulative ink and a conductive ink in this order to form a transfer material T-19.

The transfer material T-19 was set in position in a mold, and, after the clamping, tested by injecting polyethylene terephthalate resin under the conditions mentioned below.

Subsequently, the molded printed circuit was subjected to chemical plating wherein the printed circuit was immersed, at 70°C for 30 minutes, in a copper-alkaline plating bath (pH 12.3) containing copper sulfate, sodium hydroxide and formalin.

The lands were provided with copper covering as a result. The soldering properties, tested by dip soldering under conditions 260°C x 15 seconds, were such that the lands were provided with even stabilized overlay of solder.

| MOLDING (Injection) CONDITIONS | |
|---|---|
| molding machine JC150SA | made by Nippon Seikohsho Co. Ltd. |
| mold temperature | 100°C - 120°C |
| cylinder temperature | 260°C - 300°C |
| injection pressure | 1700 kg/cm² |
| dwelling pressure | 1190 - 1241 kg/cm² |
| screw revolution | 50 rpm |
| The injection speed was the maximum speed of this molding machine. | |

### EXAMPLE 9

A transfer material T-20 was obtained through a procedure wherein:
a separating layer of an epoxy resin was formed on a sheet substrate of a polyethylene terephthalate film with a thickness of 25 microns; next, a layer of circuit pattern was formed thereon with a thermosetting copper paste containing a phenolic resin as a binder and cured; and then an adhesive layer was formed in the manner of overlaying thereon with an ink of a polyimide resin.

The transfer material T-20 was set in position in a mold, and, while the mold is in position for "mold touch", a polyethylene terephthalate resin was injected into the cavity of the mold under the following conditions.

| MOLDING (Injection) CONDITIONS | |
|---|---|
| molding machine JT70-40V | made by Nippon Seikohsho Co. Ltd. |
| mold temperature | 100°C |
| cylinder temperature | (the temperature of the heater at the injection nozzle) 260°C |
| | (the temperature of the heater at the compression zone of the molten resin) 275°C |
| | (the temperature of the heater at the feed zone of the resin) 265°C |
| injection pressure | 50 kg/cm² |
| The injection speed was the maximum speed of this molding machine. | |

Then, the mold was clamped up to a pressure of 800 kg/cm², and, after the polyethylene terephthalate resin had cooled and solidified, the mold was opened and the molding taken out was separated from the sheet substrate. A printed circuit of polyethylene terephthalate resin was thus obtained.

The layer of circuit pattern in the printed circuit obtained did not show separation from the substrate but a good adhesion to it at all points. Heat treatment at 150°C for 30 minutes did not cause the printed circuit to be warped or distorted.

### ADVANTAGES OF THE INVENTION

According to the manufacturing method of the above-mentioned printed circuit, since the outermost surface layer of the layer of circuit pattern in the transfer material comprises a thermoplastic resin which starts to be thermally deformed at a temperature in the range 120°C - 300°C, the outermost surface layer of the layer of circuit pattern is not melted when it comes in contact with a molten molding resin, so that a printed circuit having an accurate circuit pattern can be produced. Moreover, said outermost surface layer is of a material which is adhesive to the molten resin, so that the circuit pattern has a good adhesion to the substrate in a printed circuit thereby produced. A printed circuit can also be produced in a simple process according to a manufacturing method embodying the present invention.

### Reference Numbers used in the drawings

1...sheet substrate, 2...layer of circuit pattern, 3...land, 4...layer of conductive pattern, 5...insulative layer, 6...substrate, 7...metal cover, 8...through holes, 9...mold, 10...molten resin, 11...cavity, 12...injection nozzle, T...transfer material, P...printed circuit

## Claims

1. A method of manufacturing a printed circuit, comprising the steps of
providing a transfer material consisting of a sheet substrate (1) and a circuit pattern layer (2) formed thereon, said circuit pattern layer containing and/or being coated with a resin forming the surface of said circuit pattern layer;
bringing the transfer material in contact with an injection molded substrate (6) under heat and pressure for transfering the circuit pattern layer (2) onto the substrate (6);
and removing the sheet substrate (1) from the substrate (6);
**characterized** in that:
a) said transfer material is placed in an injection mold (9) and is brought in contact with said substrate (6) in said injection mold simultaneously with the injection molding of the substrate (6) and
b) said resin forming the surface of the circuit pattern layer to be contacted with the substrate is a thermoplastic resin which starts to be thermally deformed at a temperature in the range 120-300°C.

2. A method as claimed in claim 1 wherein said layer of circuit pattern (2) comprises lands (3), a layer of conductive pattern (4), and an insulative layer (5).

3. A method as claimed in claim 2 wherein said land (3) comprises an ink which contains one or more of palladium, tin, indium, titanium, silver, copper, nickel or aluminium.

4. A method as claimed in claim 1, wherein said injection molding of the substrate is carried out while the mold (9) is held in a "mold touch" position with substantially no clamping force applied and forming a mold cavity larger than the final molded substrate, and after the injection molding a clamping force is applied to the mold to compress the molten resin together with the transfer material to the final shape of the printed circuit.

5. A method as claimed in claim 1 or 4, wherein two pieces of transfer material (T) are placed in the mold (9) so as to be brought in contact with the injection molded substrate at both sides thereof.

## Patentansprüche

1. Verfahren zur Herstellung einer gedruckten Schaltung, mit den Schritten:
Vorsehen eines Übertragungsmaterials, bestehend aus einem Foliensubstrat (1) und einer darauf ausgebildeten Schaltungsmusterschicht (2), wobei die Schaltungsmusterschicht ein Kunstharz enthält oder damit beschichtet ist, welches die Oberfläche der Schaltungsmusterschicht bildet;
In Kontakt bringen des Übertragungsmaterials mit einem spritzgegossenen Substrat (6) unter Wärme und Druck zur Übertragung der Schaltungsmusterschicht (2) auf das Substrat (6); und
Entfernen des Foliensubstrats (1) von dem Substrat (6);
dadurch **gekennzeichnet,** daß
a) das Übertragungsmaterial in einer Spritzgießform (9) angeordnet und mit dem Substrat (6) in der Spritzgießform gleichzeitig mit dem Spritzgießen des Substrates (6) in Kontakt gebracht wird, und
b) daß das die Oberfläche der Schaltungsmusterschicht, die in Kontakt mit dem Substrat zu bringen ist, bildende Kunstharz ein thermoplastisches Harz ist, welches bei einer Temperatur im Bereich von 120 bis 300°C beginnt, thermisch verformt zu werden.

2. Verfahren nach Anspruch 1,
bei dem die Schaltungsmusterschicht (2) Kontaktinseln (3), eine Schicht eines Leitungsmusters (4) und eine Isolierschicht (5) umfaßt.

3. Verfahren nach Anspruch 2,
bei dem die Kontaktfläche (3) aus einer Paste besteht, die Palladium, Zinn, Indium, Titan, Silber, Kupfer, Nickel und/oder Aluminium enthält.

4. Verfahren nach Anspruch 1,
bei dem das Spritzgießen des Substrats durchgeführt wird, während die Form (9) in einer "Berührungsposition" im wesentlichen ohne Aufbringung einer Schließkraft gehalten wird und einen Formhohlraum bildet, der größer als das endgültige spritzgegossene Substrat ist, und daß nach dem Spritzgießen eine Schließkraft auf die Form aufgebracht wird, um das geschmolzene Harz zusammen mit dem Übertragungsmaterial zu der endgültigen Form der gedruckten Schaltung zusammenzupressen.

5. Verfahren nach Anspruch 1 oder 4,
bei dem zwei Stücke von Übertragungsmaterial (T) in der Form (9) derart angeordnet werden, daß sie mit dem spritzgegossenen Substrat auf dessen beiden Seiten in Kontakt gebracht werden.

## Revendications

1. Procédé de fabrication d'un circuit imprimé, comprenant les étapes consistant à
réaliser une matière de transfert constituée par un substrat en feuille (1) et une couche (2) à motif de circuit formée sur celui-ci, ladite couche à motif de circuit contenant et/ou étant revêtue de résine formant la surface de ladite couche à motif de circuit; amener la matière de transfert au contact d'un substrat (6) moulé par injection avec une application de chaleur et de pression pour transférer la couche (2) à motif de circuit sur le substrat (6); et à enlever le substrat en feuille (1) du substrat (6);
caractérisé en ce que:
a) ladite matière de transfert est placée dans un moule à injection (9) et est amenée au contact dudit substrat (6) dans ledit moule à injection au moment du moulage par injection du substrat (6) et
b) ladite résine formant la surface de la couche à motif de circuit à amener au contact du substrat est une résine thermoplastique dont la déformation par la chaleur commence à une température de 120 à 300°C.

2. Procédé selon la revendication 1, dans lequel ladite couche (2) à motif de circuit comporte des plots (3), une couche de motif conducteur (4) et une couche isolante (5).

3. Procédé selon la revendication 2, dans lequel ledit plot (3) comporte une encre qui contient au moins un des métaux suivants: palladium, étain, indium, titane, argent, cuivre, nickel ou aluminium.

4. Procédé selon la revendication 1, dans lequel ledit moulage du substrat par injection est effectué pendant que le moule (9) est maintenu dans une position de "toucher de moule" dans laquelle sensiblement aucune force de serrage n'est appliquée et en formant une empreinte de moule plus grande que le substrat moulé final, et, après le moulage par injection, une force de serrage est appliquée au moule pour comprimer la résine fondue conjointement avec la matière de transfert pour obtenir la forme finale du circuit imprimé.

5. Procédé selon la revendication 1 ou 4, dans lequel deux morceaux de matière de transfert (T) sont placés dans le moule (9) de façon à être amenés au contact du substrat moulé par injection, sur les deux côtés de celui-ci.
